# EUROPÄISCHE PATENTANMELDUNG

(11) **EP 1 767 502 A1**
(43) Veröffentlichungstag der Anmeldung: **28.03.2007**
(21) Anmeldenummer: 06019745.6
(22) Anmeldetag: 21.09.2006
(51) Int. Cl.: C03B 33/033

(54) **Verfahren zur Separierung von Teilen aus einem Substrat**

(30) Priorität: 26.09.2005 DE 102005046031
(71) Anmelder: Schott AG, 55122 Mainz (DE)
(72) Erfinder: Besinger, Jörn, Dr., 84032 Landshut (DE)
(74) Vertreter: Herden, Andreas F.

(57) **Zusammenfassung**

Die Erfindung betrifft ein verbessertes Verfahren zur Herstellung einer Mehrzahl von Teilen (30) aus einem plattenförmigen Substrat (20), umfassend die Schritte:
-laterales Abtrennen der Teile (30) aus einem plattenförmigen Substrat (20), welches auf einer ersten Vakuumplatte (3) befestigt ist,
-Ansaugen der Teile (30) auf einer ersten Vakuumplatte (3), und
-Ablösen der abgetrennten Teile (30) von der ersten Vakuumplatte (3).

## Beschreibung

Die Erfindung betrifft allgemein die Separierung von Teilen aus einem Substrat, insbesondere die Separierung von Bauteilen aus Substraten mit harten oder spröden Materialien durch Herausarbeiten aus dem Substrat.

Glas eignet sich in vielen Anwendungsgebieten als Kontakt- oder Abdeckmaterial. Allerdings ist Glas schwierig zu bearbeiten, was sich insbesondere nachteilig auswirkt, wenn sehr kleine Bauteile, wie zum Beispiel Glasfenster für Optokappen, also Kappen optoelektronischer Bauelemente hergestellt werden sollen.

Für solche Anwendungen sind konventionelle Techniken der Glasbearbeitung, wie Ritzen und Brechen aufgrund der Bauteilgröße schwierig einzusetzen. Ferner erfordern die genannten Techniken im allgemeinen einen anschließende Kantenbearbeitung, welche gegebenenfalls einzeln durchgeführt werden muß. Dies ist mit erheblichen Kosten verbunden.

Um die Kosten dennoch in vertretbaren Grenzen zu halten, wird dazu oft auch im Stapelverbund gearbeitet. Hierbei werden mehrere optische Komponenten zu einem Stapel verbunden und gebohrt. Die Bearbeitung der Kanten erfolgt dann in nachteiliger Weise in einem gesonderten Arbeitsschritt. Um die Bauteile im Stapel zusammenzuhalten, werden diese üblicherweise mit Wachs oder anderen Klebersubstanzen verbunden. Zwar werden durch das Stapeln einerseits die Kosten reduziert, aber durch den Einsatz der Verbindungsmaterialien können Verschmutzungen entstehen, die dann durch aufwendige Reinigungsprozesse wieder entfernt werden müssen. Dies treibt wiederum die Kosten in die Höhe.

In der Praxis zeigt sich noch eine weitere Schwierigkeit, die das Verfahren nicht nur kostenintensiv machen, sondern auch die Qualität der Produkte erheblich beeinträchtigt. Bei der Reinigung der Gläser von den Klebersubstanzen kommt es nämlich zu Relativbewegungen zwischen den Gläsern, was häufig zu Kratzern in der Oberfläche führt. Dies wirkt sich ganz besonders nachteilig aus, wenn hochwertige und aufwendig beschichtete Gläser verarbeitet werden. Als Beispiel hierfür sei eine komplexe Entspiegelungsbeschichtung mit mehreren extrem dünnen und verschiedenartigen Schichten genannt. Aufgrund ihrer mechanischen Eigenschaften sind derartige Schichten unter Umständen besonders kratzempfindlich. So besteht bei den herkömmlichen Verfahren eine Wechselbeziehung zwischen sich zuwiderlaufenden Anforderungen an Wirtschaftlichkeit und Kosteneffizienz.

In der DE 103 37 920 A1 wird vorgeschlagen, diese Anforderungen zu erfüllen, indem ein einzelnes Glassubstrat auf einer Trägerfolie aufgebracht und dann Bauteile durch ein abtragendes Verfahren lateral voneinander getrennt werden, wobei diese zunächst mit der Folie verbunden bleiben. Allerdings müssen die Bauteile anschließend von der Folie getrennt werden, wobei wiederum Kleberückstände auf den Bauteilen verbleiben können.

Auch bei der Chip-Herstellung werden die einzelnen Chips auf einem Wafer gefertigt und anschließend abgetrennt. Das Abtrennen erfolgt hier üblicherweise durch Sägen.

Aus der US 4,138,304 ist dazu ein Verfahren zum Zerlegen eines Wafers in Teile bekannt, bei welchem der Wafer auf einer Membran befestigt und dann zersägt wird. Dabei wird ein Klebstoff verwendet, der an der Membran fester als am Wafermaterial haftet, um ein rückstandsfreies Entfernen zu ermöglichen. Allerdings muß hier die Klebeverbindung durch Abziehen von der noch bestehenden Klebeverbindung gelöst. Dies ist aufgrund der dazu erforderlichen erheblichen Krafteinwirkung nachteilig.

Auch aus der JP 06008145 A ist ein Verfahren bekannt, bei welchem aus einem Flachglas-Substrat einzelne Teile separiert werden, wobei das Substrat zur Bearbeitung mit doppelseitigem Klebeband auf einer Unterlage aufgeklebt ist. Auch in diesem Fall muß erst die Adhäsionskraft überwunden werden, um das Substrat oder die herausgetrennten Teile zu erhalten und weiterverarbeiten zu können.

Aus der DE 100 16 628 A1 ist ein Verfahren zum Herstellen von kleinen Dünnglasscheiben bekannt, welche dadurch hergestellt werden, dass die Dünnglasscheibe mittels eines Laserstrahls geritzt wird und nachfolgend durch mechanisches Brechen vereinzelt wird. Es ist dabei ferner vorgesehen, die bedruckte und geritzte Dünnglasscheibe auf eine Kunststoff-Trägerfolie aufzubringen, um das Auseinanderbrechen entlang der Rissverläufe mittels Zugkräften zu initiieren. Weiter wird vorgeschlagen, die Dünnglasscheibe mittels Trennschleifen entlang der dafür vorgesehenen Trennlinien zu zerteilen.

Bei allen diesen aus dem Stand der Technik bekannten Verfahren ergibt sich das Problem, daß die herausgetrennten Teile schwierig von der Unterlage zu trennen sind. Bei der Verwendung von Klebern oder ähnlichen Adhäsionsmitteln ergibt sich zusätzlich das Problem, daß die Oberflächen der Teile verunreinigt werden können und die Bauteile bei einer nachfolgenden Reinigung beschädigt werden können.

Demzufolge liegt der Erfindung die Aufgabe zugrunde, diese Nachteile aus dem Stand der Technik zu vermeiden oder zumindest abzumildern, insbesondere auch die Handhabung der herausgetrennten Teile und/oder des Substrats nach dem Trennvorgang zu verbessern. Diese Aufgabe wird bereits in höchst überraschend einfacher Weise durch den Gegenstand der unabhängigen Ansprüche gelöst. Vorteilhafte Ausgestaltungen und Weiterbildungen sind in den abhängigen Ansprüchen angegeben.

Demgemäß sieht die Erfindung ein Verfahren zur Herstellung einer Mehrzahl von Teilen vor, welches die Schritte umfaßt: laterales Abtrennen der Teile aus einem plattenförmigen Substrat, welches auf einer ersten Vakuumplatte befestigt ist, Ansaugen der Teile auf einer ersten Vakuumplatte, und Ablösen der abgetrennten Teile von der ersten Vakuumplatte. Eine entsprechende Vorrichtung zur Herstellung einer Mehrzahl von Teilen aus einem plattenförmigen Substrat, insbesondere zur Durchführung des erfindungsgemäßen Verfahrens umfaßt dazu eine erste Vakuumplatte zur Befestigung des plattenförmigen Substrats, eine Einrichtung zum lateralen Abtrennen der Teile aus dem Substrat, und eine Einrichtung zum Ablösen der abgetrennten Teile von der ersten Vakuumplatte.

Gemäß einer ersten Ausführungsform der Erfindung umfaßt das Verfahren die Schritte: Ansaugen des plattenförmigen Substrats auf der ersten Vakuumplatte, laterales Abtrennen der Teile, wobei die Teile während des Abtrennens auf der ersten Vakuumplatte angesaugt bleiben, und Ablösen der Teile von der ersten Vakuumplatte.

Gemäß einer weiteren Ausführungsform der Erfindung umfaßt das Verfahren die Schritte: Befestigen des plattenförmigen Substrats auf einer ersten Vakuumplatte, laterales Abtrennen der Teile, Ansaugen der abgetrennten Teile durch die erste Vakuumplatte und Ablösen der Teile von der ersten Vakuumplatte. Das Befestigen des Substrats auf der Vakuumplatte muß dabei nicht notwendigerweise durch Ansaugen erfolgen, es ist sogar möglich, das Substrat dabei auch auf andere Weise, wie etwa adhäsiv zu befestigen. Auch bei dieser Ausführungsform der Erfindung werden aber die abgetrennten Teile dann mittels eines angelegten Unterdrucks auf der Platte gehalten und fixiert. Insbesondere erfolgt dies bevorzugt ausschließlich durch Vakuum ohne den Einsatz anderer Haltemittel, wie etwa Adhäsionsmittel.

Erfindungsgemäß werden die Bauteile in beiden Fällen aus einem plattenförmigen Substrat lateral voneinander getrennt. Unter einer lateralen Trennung wird eine Trennung entlang einer lateral, also entlang einer Seitenfläche des Substrats verlaufenden Trennlinie verstanden. Dementsprechend werden aus einem plattenförmigen Substrat kleinere platten- oder plättchenförmige Teile abgetrennt. Typische Abmessungen der plättchenförmige Teile liegen dabei bei einem Durchmesser oder einer Kantenlänge von 1 bis 20 Millimetern, bevorzugt 1,5 bis 10 Millimetern. Bevorzugte Substratdicken liegen im Bereich von 0,03 bis 2 Millimetern, besonders bevorzugt im Bereich von 0,15 bis 1,5 Millimetern.

Es ist überraschend, daß eine Fixierung durch Ansaugen an eine Vakuumplatte ausreichend ist, um das Ablösen der Teile während des Herausarbeitens zu verhindern. Beim aus dem Stand der Technik bekannten Ankleben ändert sich die Kraft pro Flächeneinheit auch nach einer lateralen Trennung der Teile im wesentlichen nicht. Demgegenüber kann auf einer Vakuumplatte Luft an den Kanten der herausgearbeiteten Teile eindringen. Man würde daher eigentlich erwarten, daß der Anpreßdruck sinkt, wenn das Substrat durch das oder die Trennwerkzeuge durchtrennt wird und die Gefahr einer Ablösung oder zumindest einer Verschiebung der Teile auf der Vakuumplatte steigt. Dennoch zeigt sich, daß die auch während des Herausarbeitens auch nach der lateralen Trennung ausreichend fest und verschiebungssicher gehalten werden können.

Insbesondere wenn die herzustellenden Teile keine Kontur aufweisen, mit welcher aus einer Vielzahl derartiger aneinandergelegter Teile eine Flächenfüllung erhalten werden kann, wird das Abtrennen der einzelnen Teile jeweils bevorzugt entlang einer umlaufenden Trennlinie vorgenommen. Auf diese Weise können vorteilhaft nicht nur rechteckige oder quadratische Teile, sondern auch runde oder ovale Teile aus dem Substrat herausgearbeitet werden.

Die Erfindung läßt sich insbesondere vorteilhaft auf das Separieren von Teilen aus Substraten mit spröden oder harten Materialien anwenden. So läßt sich die Erfindung hervorragend für das Herausarbeiten von Glasteilen, insbesondere von Glasplättchen aus einem Glassubstrat einsetzen. Ebenso ist die Erfindung auch zur Bearbeitung von Quarzglas, Keramik und Glaskeramik geeignet.

Die mit der Erfindung herstellbaren Teile, sowohl in Form runder, als auch rechteckiger oder quadratischer Plättchen können besonders vorteilhaft als Fenster für Optokappen verwendet werden. Demgemäß sieht die Erfindung auch ein Verfahren zur Herstellung von Optokappen vor, bei welchem Fenster der Optokappen, insbesondere Glasfenster mit dem erfindungsgemäßen Verfahren hergestellt werden.

Das Substrat selbst ist während der Bearbeitung, insbesondere also während der Trennung auf der ersten Vakuumplatte fixiert. Die Fixierung ist derart, daß jedes einzelne Teil insbesondere während, vorzugsweise auch nach der lateralen Vereinzelung auf der Vakuumplatte fixiert bleibt.

Durch die Erfindung wird also der Einsatz von Adhäsionsmitteln, wie Kleber oder Wachse entbehrlich, wobei jedoch nicht ausgeschlossen wird, dennoch Adhäsionsmittel einzusetzen.

Gemäß einer besonders bevorzugten Ausführungsform der Erfindung erfolgt das Ablösen der Teile von der Vakuumplatte durch Abheben der Teile von der ersten Vakuumplatte mittels einer zweiten Vakuumplatte. Diese kann gemäß einer Weiterbildung der Erfindung komplementär zur ersten Vakuumplatte aufgebaut sein. Insbesondere ist es dabei von Vorteil, wenn die zweite Vakuumplatte Vakuumkanäle aufweist, die komplementär zu Vakuumkanälen der ersten Vakuumplatte angeordnet sind.

Besonders bevorzugt umfaßt weiterhin das Ablösen der Teile das Abschalten oder Vermindern des Ansaugdruckes der ersten Vakuumplatte zumindest unterhalb der lateral getrennten Teile.

Die abgehobenen Teile können nach der lateralen Trennung in Magazinen abgelegt werden, um diese dann weiterzuverarbeiten.

Vorzugsweise werden die herausgearbeiteten Teile gruppenweise oder insbesondere alle zusammen von der ersten Vakuumplatte zur Weiterverarbeitung abgelöst. Insbesondere können die Teile einzeln, oder bevorzugt gemeinsam in einem Schritt nach dem Abtrennen in einem Waschmagazin abgelegt werden. Eine erfindungsgemäße Vorrichtung umfaßt dazu entsprechend eine Einrichtung zum gleichzeitigen Ablegen mehrerer herausgearbeiteter Teile in einem Magazin, insbesondere einem Waschmagazin.

Die laterale Trennung erfolgt vorzugsweise mit einem für spröde und/oder harte Materialien besonders günstigen abrasiven Verfahren.

Geeignet als abrasive Verfahren sind Ultraschallschleifen, wie etwa Ultraschallschwingläppen und Pulverstrahlen. Das Pulverstrahlen hat den Vorzug, daß anders als beispielsweise beim Zerteilen durch Sägen Teile mit wahlfreien Konturen herausarbeitbar sind. Selbstverständlich können diese Verfahren auch für das Herausarbeiten kombiniert werden. Das Substrat kann zum Schutz der Oberfläche der herauszuarbeitenden Teile mit einer Maske bedeckt werden, welche entlang von vorgesehenen Trennlinien verlaufende Bereiche des Substrats offen läßt und Bereiche der herauszuarbeitenden Teile bedeckt. Eine derartige Abdeckung bietet sich insbesondere dann an, wenn die Einrichtung zum lateralen Abtrennen der Teile aus dem Substrat eine Pulverstrahleinrichtung umfaßt, beziehungsweise wenn das Abtrennen mit Pulverstrahlen erfolgt.

Gemäß einer Weiterbildung der Erfindung weist die erste Vakuumplatte weiterhin eine auswechselbare Auflage oder Trägerplatte für das Substrat auf. Dies ist von Vorteil, da auch bei einer Schutzschicht beispielsweise aus Kunststoff die Auflagefläche für das Substrat im Laufe der Zeit insbesondere durch Abrasionsmittel angegriffen werden kann. Bei fortgeschrittener Abnutzung kann dann einfach die Auflage ausgewechselt werden.

Bevorzugt werden zur Senkung der Herstellungskosten weiterhin mehrere Teile, bevorzugt auch alle herauszuarbeitenden Teile gleichzeitig aus dem Substrat herausgearbeitet. Beim Ultraschallschleifen kann beispielsweise ein entsprechendes Werkzeug mit mehreren Stempeln entsprechend der Anzahl der gleichzeitig abzutrennenden Teile eingesetzt werden.

Die erste Vakuumplatte ist besonders bevorzugt so ausgelegt, daß diese vom Trennverfahren nicht angegriffen wird. Insbesondere für den Einsatz abrasiver Trennverfahren hat sich eine Kunststoffbeschichtung, vorzugsweise eine Teflonbeschichtung als günstig erwiesen.

Weiterhin kann die Vakuumplatte auch Kunststoffringe, insbesondere auch elastische Ringe aufweisen, welche entlang von vorgesehenen Trennlinien eines Substrats verlaufen. Dementsprechend folgen die elastischen Ringe, vorzugsweise deren Mittelsehne der Außenkontur abzutrennender Teile. Die elastischen Ringe absorbieren die Energie des Abrasionsmediums und verhindern so einen Materialabtrag von der Vakuumplatte.

Gemäß einer Ausführungsform der Erfindung wird das Substrat auf einer ersten Vakuumplatte angesaugt, welche erhabene und vertiefte Bereiche aufweist. Die Form und Anordnung der Bereiche entspricht dabei besonders bevorzugt der Form der herauszuarbeitenden Teile und der Form des diese Teile umgebenden Substratmaterials.

Gemäß einer Weiterbildung dieser Ausführungsform wird das Substrat auf der ersten Vakuumplatte angesaugt, welche erhabene und vertiefte Bereiche aufweist, wobei die erhabenen Bereiche sich entlang der herauszuarbeitenden Teile und die vertieften Bereiche sich entlang des diese Teile umgebenden Substratmaterials erstrecken. Die Substratteile welche die herausgearbeiteten Teile umgeben, können dann in die vertieften Bereiche der ersten Vakuumplatte eingesaugt werden. Dementsprechend sind bei dieser Variante die erhabenen Bereiche zur Fixierung der herauszuarbeitenden Teile und die vertieften Bereiche zur Aufnahme und Fixierung des oder der verbleibenden Substratreste ausgebildet.

Gemäß einer anderen Weiterbildung der Erfindung wird das Substrat ebenfalls auf einer ersten Vakuumplatte angesaugt, welche erhabene und vertiefte Bereiche aufweist, wobei die vertieften Bereiche sich aber entlang der herauszuarbeitenden Teile und die erhabenen Bereiche sich entlang des diese Teile umgebenden Substratmaterials erstrecken. Die herausgearbeiteten Teile können dann nach dem lateralen Abtrennen in die vertieften Bereiche der ersten Vakuumplatte eingesaugt werden. Bei dieser Variante sind dementsprechend die vertieften Bereiche der Vakuumplatte zum Hineinsaugen der vom Substrat abgetrennten Teile ausgebildet.

Diese Variante hat den Vorteil, daß auch adhäsive Befestigungsmaßnahmen für das Substrat eingesetzt werden können, die ansonsten erfindungsgemäß wegen der möglichen Verunreinigungen an sich unerwünscht sind. So kann das plattenförmige Substrat auf den erhabenen Bereichen adhäsiv fixiert werden, ohne daß die Bereiche der abzutrennenden Teile mit dem Adhäsionsmittel in Berührung kommen.

Die Begriffe "erhaben" und "vertieft" sind im Sinne der Erfindung jeweils relativ zueinander zu verstehen. So kann die Vakuumplatte beispielsweise Vertiefungen in einer ansonsten ebenen Auflagefläche aufweisen. Auch in diesem Fall werden die Bereiche, welche die Vertiefungen umgeben, im Sinne der Erfindung als "erhabene" Bereiche verstanden. Ebenso wird eine Fläche, aus der erhabene Strukturen hervorstehen, als ein vertiefter, nämlich gegenüber den erhabenen Strukturen vertiefter Bereich verstanden.

Auch ist gemäß noch einer Weiterbildung der Erfindung vorgesehen, daß erste, den herauszuarbeitenden Teilen zugeordnete Bereiche und einen oder mehrere zweite, dem diese Teile umgebende Bereiche des plattenförmigen Substrats getrennt, beziehungsweise selektiv gesteuert angesaugt werden. Eine Vorrichtung zur Durchführung dieser Weiterbildung der Erfindung weist demnach erste Bereiche insbesondere zur Fixierung der abgetrennten Teile und zumindest einen zweiten Bereich auf, wobei die ersten Bereiche und der zumindest eine zweite Bereich separat an eine Unterdruckerzeugungseinrichtung angeschlossen sind.

Auf diese Weise können beispielsweise nach der lateralen Abtrennung der Teile die Ansaugung für die restlichen Substratbereiche unterbrochen und die Substratreste entfernt werden, wobei die herausgearbeiteten Teile angesaugt bleiben. Umgekehrt können auch erst die herausgearbeiteten Teile abgelöst werden, wobei der Unterdruck unter diesen Teilen aufgehoben wird, während die Substratreste angesaugt bleiben. Auf diese Weise wird beispielsweise verhindert, daß Reste des Substrats mit in die Magazine gelangen können, in welchen die herausgearbeiteten Teile abgelegt werden.

Um eine reproduzierbare Positionierung des Substrats auf der ersten Vakuumplatte zu gewährleisten, kann das plattenförmige Substrat vorteilhaft in einer dafür vorgesehenen Vertiefung der ersten Vakuumplatte zentriert werden.

Das plattenförmige Substrat kann beispielsweise eine quadratische oder rechteckige Platte sein. Weiterhin können auch runde plattenförmige Substrate, insbesondere auch Wafer verwendet werden. Es ist außerdem nicht nur möglich, die herausgetrennten Teile zur verwenden, vielmehr kann alternativ oder zusätzlich auch das gelochte plattenförmige Substrat zur Weiterverarbeitung verwendet werden. Beispielsweise kann auf diese Weise ein Wafer hergestellt werden, der Öffnungen aufweist. Wird ein solcher Wafer mit einem Funktionswafer verbunden, so können die Öffnungen beispielsweise auf Funktionsbereiche des Funktionswafers zu liegen kommen. Wird ein zusätzlicher Abdeckwafer aufgebracht, können die Öffnungen dann zusammen mitdem Abdeckwafer Cavities um die Funktionsbereiche, wie etwa Sensorbereiche bilden.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können. Es zeigen:
- Fig. 1: eine schematische Ansicht einer Vakuumplatte zur Fixierung eines Substrats,
- Fig. 2: eine Querschnittansicht einer erfindungsgemäßen Vorrichtung zur Herstellung einer Mehrzahl von Teilen aus einem plattenförmigen Substrat mit einer Vakuumplatte entsprechend Fig. 1,
- Fig. 3: das Abheben von aus einem Substrat mit der in Fig. 2 gezeigten Vorrichtung abgetrennten Teilen,
- Fig. 4: das Ablegen der abgetrennten Teile in ein Magazin,
- Fig. 5: ein Ausführungsbeispiel einer ersten Vakuumplatte mit erhabenen und vertieften Bereichen,
- Fig. 6: ein Ausführungsbeispiel einer erfindungsgemäßen Vorrichtung mit einer wie in Fig. 5 dargestellten Vakuumplatte,
- Fig. 7: das in Fig. 6 gezeigte Ausführungsbeispiel nach dem lateralen Abtrennen von Teilen aus einem Substrat,
- Fig. 8: ein weiteres Ausführungsbeispiel einer ersten Vakuumplatte mit erhabenen und vertieften Bereichen,
- Fig. 9: ein Querschnitt durch eine erfindungsgemäße Vorrichtung 1 mit einer wie in Fig. 8 dargestellten Vakuumplatte,
- Fig. 10: das Abheben der mit der in Fig. 9 gezeigten Vorrichtung hergestellten Teile mittels einer zweiten Vakuumplatte,
- Fig. 11: ein optoelektronisches Bauelement mit einem erfindungsgemäß hergestellten Teil,
- Fig. 12: einen gelochten Wafer, welcher durch Heraustrennen von Teilen aus dem Wafermaterial hergestellt wurde, und
- Fig. 13: einen Waferverbund mit dem in Fig. 12 dargestellten Wafer.

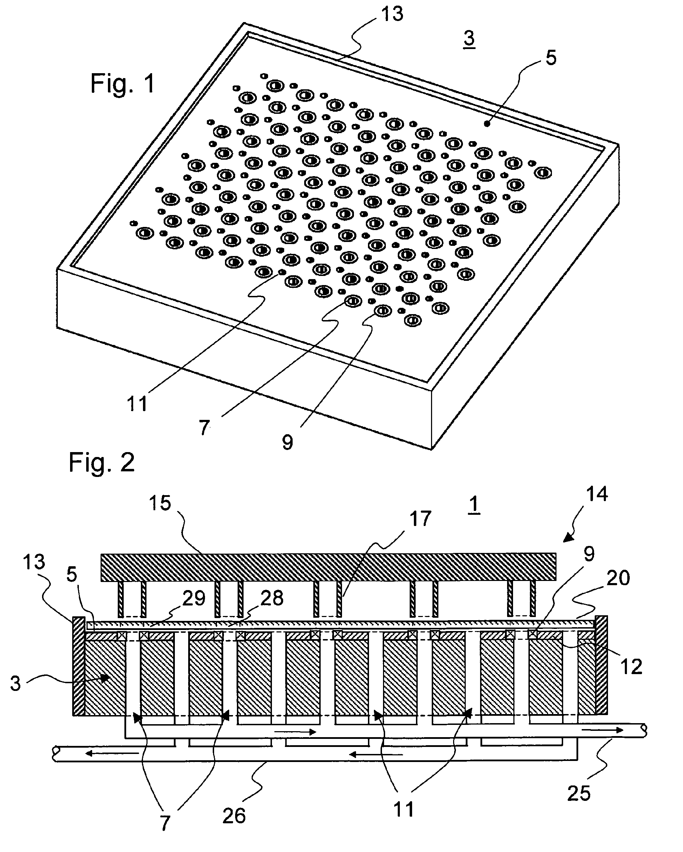

Fig. 1 zeigt eine schematische Ansicht eines Ausführungsbeispiels einer Vakuumplatte 3, wie sie zur Fixierung eines plattenförmigen Substrats während der Abtrennung einer Mehrzahl von Teilen daraus gemäß der Erfindung eingesetzt werden kann. Die Vakuumplatte 3 umfaßt eine Vielzahl von Kanälen 7 und 11, welche in eine Auflagefläche 5 für das nicht dargestellte Substrat münden. Eine erste Gruppe von Kanälen 7 ist von elastischen Ringen 9 umgeben. Diese Gruppe von Kanälen dient zur Fixierung der abzutrennenden Substratbereiche, also der herzustellenden Teile, während die anderen Kanäle zur Fixierung der diese Teile umgebenden Substratbereiche vorgesehen sind.

Die in Fig. 1 gezeigte Vakuumplatte 3 ist insbesondere für das Heraustrennen runder Glasplättchen aus einer dünnen Glasplatte vorgesehen.

Das Abtrennen der einzelnen Glasplättchen erfolgt dabei jeweils entlang von gedachten umlaufenden Trennlinien. Diese erstrecken sich insbesondere entlang der elastischen Ringe 9. Auf diese Weise wird die Energie des Abrasionsmediums nach dem Durchdringen des Substrats gedämpft und die Vakuumplatte wird nicht beschädigt.

Als weitere Schutzmaßnahme kann die Auflagefläche 5 außerdem kunststoffbeschichtet, vorzugsweise teflonbeschichtet sein, um ein Verkratzen der herauszuarbeitenden Teile zu vermeiden.

Die Vakuumplatte 3 umfaßt außerdem einen Rahmen 13, welcher über die Auflagefläche 5 hinausragt, so daß eine Vertiefung gebildet wird. Das Substrat wird zur Bearbeitung in die Vertiefung eingelegt und auf diese Weise seitlich positioniert und zentriert. Der Rahmen 13 kann sowohl fest, als auch für die Zentrierung des Substrats 20 zusammenfahrbar ausgestaltet sein.

Fig. 2 zeigt eine Querschnittansicht einer erfindungsgemäßen Vorrichtung zur Herstellung einer Mehrzahl von Teilen aus einem plattenförmigen Substrat 20. Die Vorrichtung umfaßt dabei eine wie in Fig. 1 dargestellte erste Vakuumplatte 3.

Die laterale Abtrennung von Teilen aus dem Substrat 20 wird bei dem in Fig. 2 gezeigten Beispiel mittels Ultraschallschleifen, insbesondere durch Ultraschallschwingläppen durchgeführt. Das Substrat 20 ist aus sprödem oder harten Material, wie etwa Quarzglas, Keramik oder Glaskeramik, besonders bevorzugt aus Glas, welches hervorragend erfindungsgemäß eingesetzt werden kann, um daraus Teile in Form kleiner Glasplättchen herauszuarbeiten, wie sie etwa als Fenster für die Herstellung von Optokappen verwendet werden.

Dazu ist eine Ultraschallschleifeinrichtung mit einer Sonotrode 15 und mehreren daran befestigten Läppstempeln 17 vorgesehen. Die Läppstempel 17 weisen für das Heraustrennen von runden Glasplättchen entlang einer umlaufenden Trennlinie eine kreisförmige Schleiffläche auf. Die Läppstempel bearbeiten das Substrat 20 gleichzeitig, so daß dementsprechend auch mehrere Teile gleichzeitig aus dem Substrat herausgearbeitet werden. Bei diesem Ausführungsbeispiel wird das plattenförmige Substrat 3 auf der ersten Vakuumplatte 3 angesaugt und die Teile lateral abgetrennt wobei die Teile während des Abtrennens und auch danach auf der ersten Vakuumplatte 3 angesaugt und dadurch fixiert bleiben.

Die Vakuumplatte 3 weist weiterhin eine auswechselbare Auflage 12 für das Substrat 20 auf. Wird die Auflagefläche 5 durch die Läppstempel 15 abgenutzt, so kann die Auflage 12 ausgetauscht werden, ohne daß die gesamte Vakuumplatte 3 ausgewechselt werden muß. Die Auflage 12 umfaßt bevorzugt Materialien, welche die Energie des Abrasionsmedium absorbieren können, vorzugsweise Gummi, Teflon oder ähnliche Kunststoffe.

Bei dem in Fig. 2 gezeigten Beispiel weist die erste Vakuumplatte 3 außerdem erste Bereiche zur Fixierung der aus dem Substrat 20 abzutrennenden Teile und zumindest einen zweiten Bereich auf, wobei die ersten Bereiche und der zumindest eine zweite Bereich separat an eine Unterdruckerzeugungseinrichtung angeschlossen sind. Damit können erste, den herauszuarbeitenden Teilen zugeordnete Bereiche 28 und zweite, dem diese Teile umgebende Bereiche oder Teile 29 des plattenförmigen Substrats selektiv angesteuert angesaugt werden. Im Speziellen sind die Kanäle 7 zum Ansaugen der abzutrennenden Teile an ein erstes Unterdruck-Leitungssystem 25 und die Kanäle 11, welche unterhalb des oder der Bereiche 29 in die Auflagefläche 5 münden, an ein zweites Unterdruck-Leitungssystem 26 angeschlossen.

Damit kann der Unterdruck selektiv für die Bereiche 28, beziehungsweise die aus diesen Bereichen durch laterales Abtrennen gebildeten Teile und die umgebenden Substratreste zu- oder abgeschaltet werden. Damit ist es beispielsweise möglich, die herausgearbeiteten Teile selektiv abzulösen, indem der Unterdruck im Leitungssystem 25 ausgeschaltet wird, während der Unterdruck im Leitungssystem 26 aufrechterhalten wird und die Substratreste, beziehungsweise die Bereiche 29 auf der Vakuumplatte 3 fixiert bleiben.

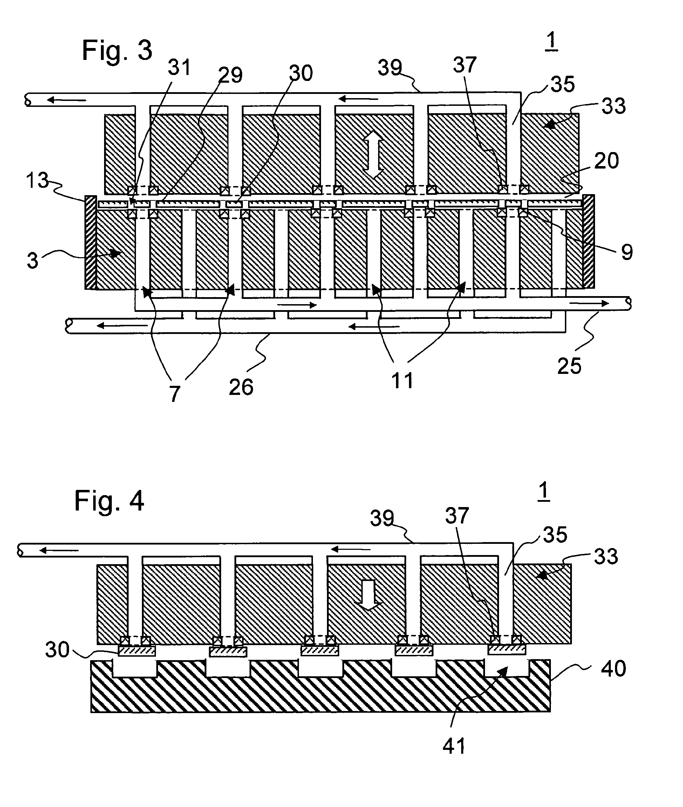

Fig. 3 zeigt einen nachfolgenden Verfahrensschritt mit der in Fig. 2 dargestellten Vorrichtung 1. Aus dem Substrat 20 sind hier die herzustellenden Teile 30 durch die Läppstempel lateral abgetrennt worden. Dabei wurde ein um die Kante der Teile 30 umlaufender Zwischenraum 31 zwischen den Teilen 30 und den Resten des Substrats 20, beziehungsweise den Bereichen 29 durch Materialabtrag erzeugt.

Sowohl die lateral abgetrennten Teile 30, als auch das Restmaterial des Substrats 20 werden durch Ansaugen mittels der Kanäle 7, beziehungsweise 11 auf dem Substrat fixiert. Anschließend erfolgt nun das Ablösen der abgetrennten Teile 30 von der ersten Vakuumplatte 3. Das Ablösen der Teile 30 von der Vakuumplatte 3 erfolgt bei dieser Ausführungsform der Erfindung durch Abheben der Teile 30 von der ersten Vakuumplatte 3 mittels einer zweiten Vakuumplatte 33. Dabei werden die herausgearbeiteten Teile 30 gruppenweise, insbesondere sogar alle zusammen abgelöst.

Diese zweite Vakuumplatte 33 weist ebenfalls an ein Unterdruckleitungssystem 39 angeschlossene Kanäle 35 auf, mit welchen die Teile 30 angesaugt werden. Um dies zu erreichen, ist die zweite Vakuumplatte 33 hinsichtlich der Anordnung der Kanäle komplementär zur ersten Vakuumplatte 3 aufgebaut.

Um ein Verkratzen der abgetrennten Teile 30 zu vermeiden, kann auch die zweite Vakuumplatte 33 mit elastischen Ringen 37 und/oder einer Kunststoffbeschichtung, insbesondere einer Teflonbeschichtung versehen sein. Um die Teile 30 Abzulösen wird über das Unterdruckleitungssystem 25 der Ansaugdruck unterhalb der Teile 30 abgeschaltet oder vermindert, beispielsweise durch Belüften der Leitungen. Durch die Kanäle 35 der zweiten Vakuumplatte 33 werden die Teile 30 dann an dieser Platte 33 angesaugt und können abgehoben werden. Durch eine entsprechende Anordnung der Kanäle 37, insbesondere entsprechend den Kanälen 7 der ersten Vakuumplatte wird erreicht, daß nur die abgetrennten Teile 30, nicht aber umgebende Bereiche 29 des Restsubstrats angesaugt werden. Um ein Abheben restlicher Teile des Substrats 20 zu verhindern, kann zusätzlich der Unterdruck im Leitungssystem 26 aufrechterhalten werden, so daß diese Bereiche 29 an der ersten Vakuumplatte 3 angesaugt bleiben.

In Fig. 4 ist ein weiterer Verarbeitungsschritt dargestellt. Die abgetrennten Teile 30 sind an der zweiten Vakuumplatte 33 angesaugt und werden zu einem Waschmagazin 40 mit Aufnahmen 41 transportiert. Durch Vermindern oder Abschalten, beziehungsweise Unterbrechen des Ansaugdruckes über das Unterdruckleitungssystems 39 werden die Teile 30 dann gemeinsam, beziehungsweise gleichzeitig von der zweiten Vakuumplatte 33 abgelöst und in die Aufnahmen 41 des Waschmagazins 40 abgelegt.

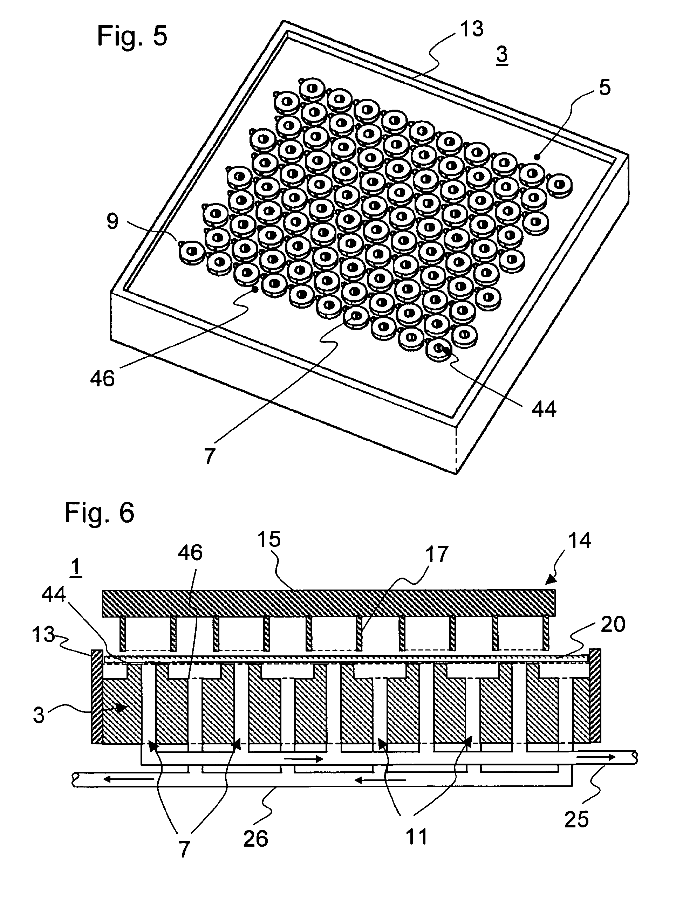

Fig. 5 zeigt ein weiteres Ausführungsbeispiel einer ersten Vakuumplatte 3. Im Unterschied zu dem in Fig. 1 dargestellten Beispiel weist die in Fig. 5 gezeigte Vakuumplatte 3 erhabene Bereiche 44 und vertiefte Bereiche 46 auf. Dabei erstrecken sich die erhabenen Bereiche 44 entlang der herauszuarbeitenden Teile und die vertieften Bereiche entlang des diese Teile umgebenden Substratmaterials. Die kreisförmigen Erhebungen 44, in welche die Kanäle 7 zum Ansaugen der abzutrennenden Teile münden, entsprechen demgemäß in ihrer lateralen Abmessung und Kontur den herzustellenden Teilen. Die Vakuumplatte 3, wie sie in Fig. 5 dargestellt wird, dient demgemäß zur Herstellung runder Teile aus einem plattenförmigen Substrat. Auch hier wird das Substrat in einer durch den umlaufenden Rahmen 13 definierten Vertiefung zentriert.

Fig. 6 zeigt im Querschnitt ein Ausführungsbeispiel einer erfindungsgemäßen Vorrichtung 1 zur Herstellung einer Mehrzahl von Teilen 30 aus einem plattenförmigen Substrat 20 mit einer solchen Vakuumplatte 3. Das zu bearbeitende Substrat 20 liegt dabei zunächst auf den erhabenen Bereichen 44 der Vakuumplatte auf und wird durch den Unterdruck der Kanäle 7 angesaugt. Das laterale Abtrennen von Teilen 30 aus dem Substrat 20 erfolgt ebenfalls durch Ultraschallschwingläppen mittels einer Ultraschallschleifeinrichtung 14 mit einer Sonotrode 15 und daran angebrachter Schleifwerkzeuge 17. Das Muster der relativen Position der Teile zueinander entspricht wie bei dem in Fig. 2 gezeigten Beispiel der Anordnung der formgebenden Werkzeuge, beziehungsweise der Schleifwerkzeuge 17 auf der Sonotrode 15.

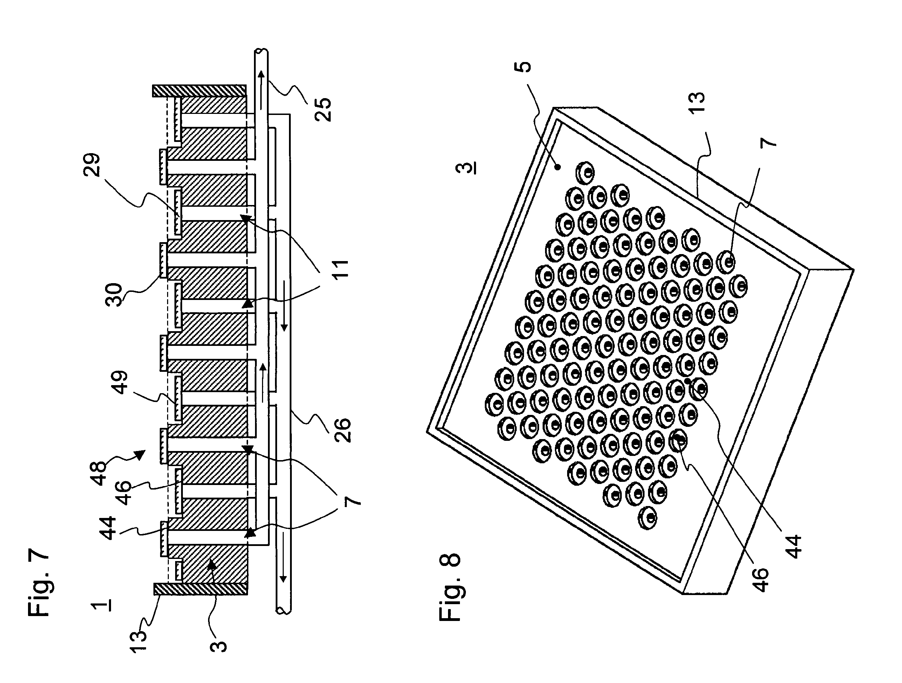

Fig. 7 zeigt die Vorrichtung nach dem lateralen Abtrennen von Teilen 30. Mittels der Vakuumkanäle 11 der ersten Vakuumplatte 3 sind dabei die Substratteile, welche die herausgearbeiteten Teile 30 umgeben, in die vertieften Bereiche 46 der Vakuumplatte 3 eingesaugt worden. Auch die lateral durch Entfernen des Substratmaterials im Bereich der kreisförmigen Schleiffläche der Schleifwerkzeuge 17 abgetrennten Teile 30 bleiben bis zum Ablösen, insbesondere für das Ablegen in ein Waschmagazin angesaugt.

Das Ablösen und Ablegen der Teile 30 kann dabei entsprechend wie in den Fig. 3 und 4 dargestellt mittels einer komplementären zweiten Vakuumplatte 33 erfolgen. Da die Bereiche 44, auf welchen die Teile 30 auf der ersten Vakuumplatte 3 angesaugt werden, erhaben sind, ist es auch möglich, die Teile direkt von der ersten Vakuumplatte 3 in ein Waschmagazin abzulegen. Dazu wird die Vakuumplatte 3 mit der Auflagefläche 5 nach unten hängend angeordnet und der Unterdruck im Unterdruckleitungssystem vermindert, so daß die Teile 30 in die Aufnahmen eines Waschmagazins fallen. Auch das Herausarbeiten der Teile 30 kann selbstverständlich bereits in einer solchen Anordnung mit hängend fixiertem Substrat vorgenommen werden. Ebenso ist dies auch mit allen anderen Ausführungsformen der Erfindung möglich.

Fig. 8 zeigt ein weiteres Ausführungsbeispiel einer ersten Vakuumplatte mit erhabenen und vertieften Bereichen. Bei diesem Beispiel weist die Vakuumplatte 3 vertiefte Bereiche 44 auf, welche von einem erhabenen Bereich 46 umgeben sind, wobei die vertieften Bereiche 44 den aus einem Substrat herauszuarbeitenden Teilen zugeordnet sind und diesen Teilen in Form und Abmessung entsprechen. Dementsprechend wird hier das Substrat auf einer ersten Vakuumplatte 3 befestigt, welche erhabene und vertiefte Bereiche 44, beziehungsweise 46 aufweist, wobei die vertieften Bereiche 46 sich entlang der herauszuarbeitenden Teile 30 und die erhabenen Bereiche sich entlang des diese Teile 30 umgebenden Substratmaterials 29 erstrecken. Die Kanäle 7 zum Ansaugen der Teile in die vertieften Bereiche 44 münden hier in die vertieften Bereiche 46. Im Unterschied zu den vorangegangenen Beispielen sind jedoch keine Kanäle 11 zum Ansaugen des umgebenden Substratmaterials vorhanden.

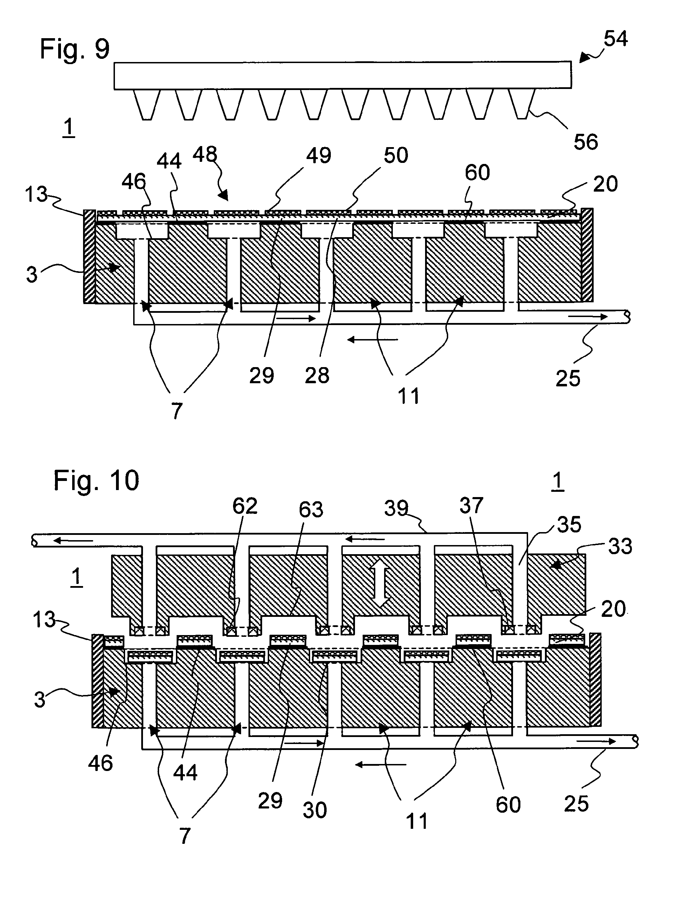

In Fig. 9 ist ein Querschnitt durch eine erfindungsgemäße Vorrichtung 1 mit einer derart strukturierten Vakuumplatte 3 dargestellt. Die Fixierung des Substrats 20 erfolgt bei diesem Beispiel nicht durch Ansaugen, sondern vielmehr durch ein auf dem erhabenen Bereich aufgebrachtes Adhäsionsmittel 60. Das Adhäsionsmittel kann beispielsweise ein doppelseitiges Klebeband oder Kitt umfassen.

Bei diesem Ausführungsbeispiel erfolgt die laterale Trennung der Teile, beziehungsweise das Herausarbeiten aus dem Substrat 20 außerdem durch Pulverstrahlen. Dazu ist eine Pulverstrahleinrichtung 54 mit mehreren Pulverstrahldüsen 56 in Gegenüberstellung zum Substrat angeordnet. Um eine zielgerichtete Bearbeitung mit den aus den Düsen 56 austretenden Pulverstrahlen zu erreichen und nur entlang der vorgesehenen, insbesondere umlaufenden Trennlinien Substratmaterial abzutragen, wird das Substrat 20 mit einer Maske 48 bedeckt, welche entlang der vorgesehenen Trennlinien verlaufende Bereiche 50 des Substrats 20 offen läßt und Bereiche 49 der herauszuarbeitenden Teile 30 bedeckt. Die Maske 48 kann beispielsweise eine Photomaskierung sein. Ebenso kann die Maske auch beispielsweise aufgedruckt werden. Während des Pulverstrahlprozesses wird das Substratmaterial an den nicht maskierten Bereichen 50 abgetragen.

Auch bei diesem Ausführungsbeispiel werden die heruszuarbeitenden Teile 30 auf der ersten Vakuumplatte 3 angesaugt, jedoch nicht zur Fixierung des Substrats. Vielmehr erfolgt hier zuerst das laterale Abtrennen der Teile 30, welche dann durch die Kanäle 7 in den vertieften Bereichen angesaugt werden. Insbesondere werden die herausgearbeiteten Teile 30 nach dem lateralen Abtrennen in die vertieften Bereiche 44 der ersten Vakuumplatte 3 eingesaugt und dann darin fixiert. Dieser Zustand ist in Fig. 10 dargestellt. Obwohl hier zwar ein Adhäsionsmittel 60 eingesetzt wird, wird aber dennoch ein Kontakt der Teile 30 mit dem Adhäsionsmittel vermieden, da das Adhäsionsmittel nur mit den umgebenden Substratbereichen 29 in Berührung kommt. Um Beschädigungen der Teile beim Einsaugen in die vertieften Bereiche 46 zu vermeiden, können die Vertiefungen auch wieder mit einem Kunststoffmaterial, wie Teflon oder einem geeigneten Elastomer versehen sein.

Als Einrichtung zum Ablösen der abgetrennten Teile 30 von der ersten Vakuumplatte 3 ist auch bei diesem Ausführungsbeispiel eine komplementär zur ersten Vakuumplatte 3 aufgebaute zweite Vakuumplatte 22 vorgesehen. Diese weist bei dem in Fig. 10 gezeigten Beispiel nicht nur eine komplementäre Anordnung von Kanälen 35, sondern auch komplementäre erhabene und vertiefte Bereiche 63, beziehungsweise 63 auf, wobei die erhabenen Bereiche 62 zum Abheben der Teile 30 in die vertieften Bereiche 46 der ersten Vakuumplatte 3 eingreifen können. Durch Anlegen eines Saugdrucks an das Unterdruckleitungssystem 39 der zweiten Vakuumplatte 33 und das Vermindern oder Unterbrechen des Saugdrucks am Unterdruckleitungssystem 25 der ersten Vakuumplatte 3 werden dann die Teile 30 an der zweiten Vakuumplatte 33 festgesaugt und fixiert und können dann mit der zweiten Vakuumplatte 33 abgehoben werden. Anschließend werden die Teile 30 dann wie in Fig. 4 dargestellt, in einem Waschmagazin 40 abgelegt.

Fig. 10 zeigt ein Beispiel für die Verwendung der Erfindung. In Fig. 10 ist im Speziellen ein gehäustes optoelektronisches Bauelement 70 dargestellt. Das optoelektronische Bauelement kann beispielsweise ein optischer Sensor oder eine Laserdiode sein. Die Gehäusung umfaßt eine Optokappe 72, beispielsweise aus Blech, Edelstahl, einer Legierung, welche mit einer Krempe 73 auf einem Sockel 74 mit Anschlußbeinen 45 verbunden ist.
Auf dem Sockel 73 in der Optokappe eingeschlossen befindet sich die optoelektronische Komponente. Ein erfindungsgemäß herstellbares Teil 30 in Form einer Glasscheibe verschließt eine Öffnung der Optokappe und dient als Fenster für die optoelektronische Komponente. Um die Optokappe 72 mit dem Teil 30 herzustellen, kann das Teil 30 beispielsweise mit Glaslot in das Gehäuse der Optokappe eingelötet werden.

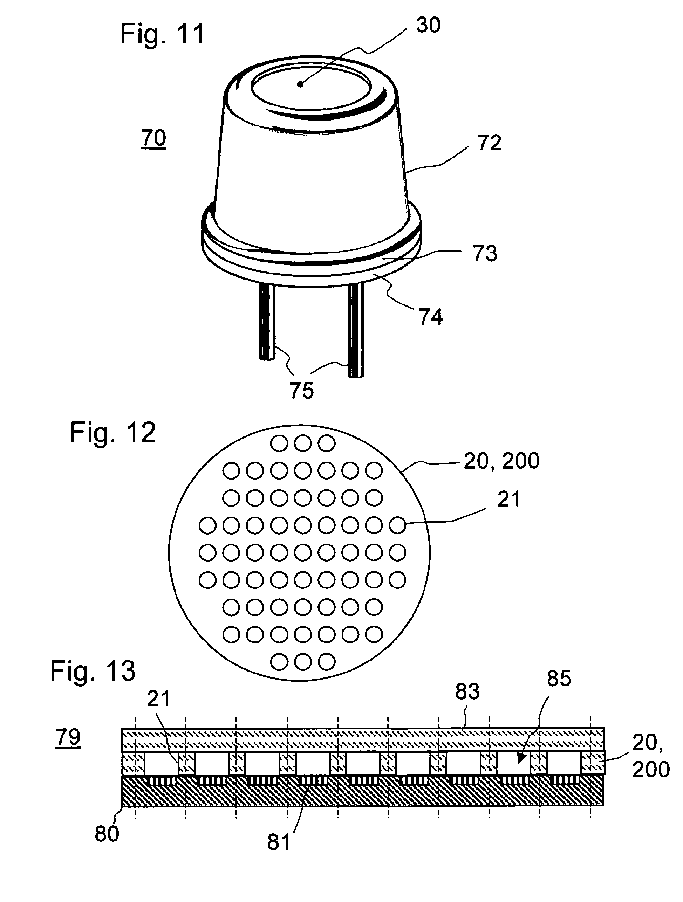

Bei dem in Fig. 11 gezeigten Beispiel werden die aus dem Substrat 20 herausgetrennten Teile 30 verwendet. Gemäß einer weiteren, alternativen oder zusätzlichen Ausführungsform der Erfindung kann aber auch das wie vorstehend beschriebene Substrat 20 verwendet werden. Ein solches Beispiel wird nachfolgend anhand der Fig. 12 und 13 erläutert. Bei den bisher erläuterten Beispielen wurden rechteckförmige oder quadratische Substrate 20 verwendet. Selbstverständlich können aber auch andere Substratformen, wie etwa runde, plattenförmige Substrate eingesetzt werden. Gedacht ist hier insbesondere an Wafer, vorzugsweise Glaswafer.

Generell ist dabei gemäß dieser Ausführungsform der Erfindung vorgesehen, einen Wafer durch Heraustrennen von Teilen, insbesondere wie oben beschrieben zu bearbeiten, so daß ein Wafer mit einer Vielzahl von Löchern oder Durchgangsöffnungen erhalten wird und mit diesen Wafer und einem weiteren Wafer, insbesondere einem Funktionswafer einen Waferverbund herzustellen.

Einen Wafer 200 als Substrat 20 nach der Bearbeitung zeigt in Aufsicht Fig. 12. Der Wafer 200 weist nach dem Heraustrennen der Teile 30 dementsprechend eine Mehrzahl von Löchern oder Durchgangsöffnungen 21 auf. Der Wafer 200 selbst wird nun weiterverarbeitet, wobei ein Verbund mit einem Funktionswafer hergestellt wird. Fig. 13 zeigt einen solchen Verbund 79. Der Wafer 200 mit der Vielzahl von Durchgangsöffnungen 21 ist auf einen Funktionswafer 80 gebondet. Als Funktionswafer wird dabei allgemein ein Wafer verstanden, Funktionsbereiche mit elektronischen und/oder optoelektronischen und/oder mikroelektromechanischen Bauelementen aufweist. Bei dem in Fig. 13 gezeigten Beispiel ist der Wafer 200 so auf die Funktionsseite des Funktionswafers 80 gebondet, daß die Funktionsbereiche 81 jeweils in den Löchern 21 angeordnet, beziehungsweise jeweils vom Rand einer Durchgangsöffnung 21 umgeben sind. Auf den Wafer 200 ist ein weiterer Wafer 83 als Abdeckwafer gebondet, so daß mit den Durchgangsöffnungen 21 Kavitäten 85 gebildet werden, welche die Funktionsbereiche umschließen. Vorzugsweise wird eine hermetische Verkapselung der Funktionsbereiche erreicht. Umfassen die Funktionsbereiche optoelektronische Bauelemente, so wird vorzugsweise ein transparenter Abdeckwafer 83 eingesetzt. Auf diesen Abdeckwafer 83 können beispielsweise dann auch weitere optische Elemente aufgesetzt werden, oder der Abdeckwafer 83 kann selber integrierte optische Elemente, wie insbesondere Linsen aufweisen. In diesem Fall kann der erfindungsgemäß bearbeitete Wafer 200 besonders vorteilhaft als präziser Abstandhalter für die optischen Element dienen. Um einzelne Chips aus dem Waferverbund 79 zu erhalten, können die einzelnen Bauteile dann anhand von vorgesehenen, gestrichelt eingezeichneten Trennlinien vom Waferverbund 79 abgetrennt werden.

Es ist dem Fachmann ersichtlich, dass die Erfindung nicht auf die vorstehend beschriebenen beispielhaften Ausführungsformen beschränkt ist, sondern vielmehr in vielfältiger Weise variiert werden kann. Insbesondere können die Merkmale der einzelnen Ausführungsbeispiele auch miteinander kombiniert werden.

### Bezugszeichenliste

- 1: Vorrichtung zur Herstellung einer Mehrzahl von Teilen aus einem plattenförmigen Substrat
- 3: erste Vakuumplatte
- 5: Auflagefläche für Substrat
- 7: erste Kanäle zur Fixierung herauszuarbeitender Teile
- 9, 37: elastischer Ring
- 11: zweite Kanäle zur Fixierung von Restmaterial eines Substrats
- 12: auswechselbare Auflage von 3
- 13: Rahmen
- 14: Ultraschallschleifeinrichtung
- 15: Sonotrode
- 17: Läppstempel
- 20: plattenförmiges Substrat
- 21: Durchgangsöffnungen in 20
- 25, 26, 39: Unterdruck-Leitungssysteme
- 28, 29: Bereiche des Substrats 20
- 30: von 20 abgetrenntes Teil
- 31: Zwischenraum
- 33: zweite Vakuumplatte
- 35: Kannäle in 33
- 40: Waschmagazin
- 41: Aufnahme von 40 für Teil 30
- 44: erhabene Bereiche von 5
- 46: vertiefte Bereiche von 5
- 48: Maske
- 49: durch 48 bedeckte Bereiche
- 50: Lücken von 48, von 48 offen gelassene Bereiche
- 54: Pulverstrahleinrichtung
- 56: Pulverstrahldüsen von 54
- 60: Adhäsionsmittel
- 62: erhabener Bereich von 33
- 63: vertiefter Bereich von 33
- 70: Optoelektronisches Bauelement
- 72: Optokappe von 70
- 73: Krempe von 72
- 74: Sockel von 70
- 75: Anschlußbeine
- 79: Waferverbund
- 80: Funktionswafer
- 81: Funktionsbereiche von 80
- 83: Abdeckwafer
- 85: Kavität
- 200: Wafer

## Patentansprüche

1. Verfahren zur Herstellung einer Mehrzahl von Teilen (30) aus einem plattenförmigen Substrat (20) oder zur Herstellung eines gelochten plattenförmigen Substrats, umfassend die Schritte:
- laterales Abtrennen der Teile (30) aus einem plattenförmigen Substrat (20), welches auf einer ersten Vakuumplatte (3) befestigt ist,
- Ansaugen der Teile (30) auf einer ersten Vakuumplatte (3), und
- Ablösen der abgetrennten Teile (30) von der ersten Vakuumplatte (3).

2. Verfahren gemäß Anspruch 1, umfassend die Schritte:
- Ansaugen des plattenförmigen Substrats (20) auf einer ersten Vakuumplatte (3),
- laterales Abtrennen der Teile, wobei die Teile (30) während des Abtrennens auf der ersten Vakuumplatte (3) angesaugt bleiben, und
- Ablösen der Teile (30) von der ersten Vakuumplatte (3).

3. Verfahren gemäß Anspruch 1, umfassend die Schritte:
- Befestigen des plattenförmigen Substrats (20) auf einer ersten Vakuumplatte (3),
- laterales Abtrennen der Teile (30),
- Ansaugen der abgetrennten Teile (30) durch die erste Vakuumplatte (3) und
- Ablösen der Teile (30) von der ersten Vakuumplatte (3).

4. Verfahren gemäß Anspruch 1 oder 2, **dadurch gekennzeichnet, daß** das Ablösen der Teile (30) von der Vakuumplatte (3) das Abheben der Teile (30) von der ersten Vakuumplatte (3) mittels einer zweiten Vakuumplatte (33) umfaßt.

5. Verfahren gemäß Anspruch 1 oder 2, **dadurch gekennzeichnet, daß** das Ablösen der Teile (30) das Abschalten oder Vermindern des Ansaugdruckes der ersten Vakuumplatte (3) zumindest unterhalb der lateral getrennten Teile (30) umfaßt.

6. Verfahren gemäß einem der vorstehenden Ansprüche, **dadurch gekennzeichnet, daß** die herausgearbeiteten Teile (30) gruppenweise oder alle zusammen abgelöst werden.

7. Verfahren gemäß einem der vorstehenden Ansprüche, **dadurch gekennzeichnet, daß** die Teile (30) nach dem Abtrennen in einem Waschmagazin (40) abgelegt werden.

8. Verfahren gemäß einem der vorstehenden Ansprüche, **dadurch gekennzeichnet, daß** die Teile (30) aus einem Substrat (20) mit sprödem oder harten Material, insbesondere Glas, Quarzglas, Keramik und Glaskeramik herausgearbeitet werden.

9. Verfahren gemäß einem der vorstehenden Ansprüche, **dadurch gekennzeichnet, daß** Glasteile, insbesondere Glasplättchen aus einen Glassubstrat (20) abgetrennt werden.

10. Verfahren gemäß einem der vorstehenden Ansprüche, **dadurch gekennzeichnet, daß** runde oder ovale Teile (30) aus dem Substrat (20) herausgearbeitet werden.

11. Verfahren gemäß einem der vorstehenden Ansprüche, **dadurch gekennzeichnet, daß** das Abtrennen der einzelnen Teile (30) jeweils entlang einer umlaufenden Trennlinie durchgeführt wird.

12. Verfahren gemäß einem der vorstehenden Ansprüche, **dadurch gekennzeichnet, daß** die laterale Trennung der Teile (30) durch Ultraschallschleifen erfolgt.

13. Verfahren gemäß einem der vorstehenden Ansprüche, **dadurch gekennzeichnet, daß** die laterale Trennung der Teile (30) durch Pulverstrahlen erfolgt.

14. Verfahren gemäß einem der vorstehenden Ansprüche, **dadurch gekennzeichnet, daß** das Substrat (20) mit einer Maske bedeckt wird, welche entlang von vorgesehenen Trennlinien verlaufende Bereiche des Substrats (20) offen läßt und Bereiche der herauszuarbeitenden Teile (30) bedeckt.

15. Verfahren gemäß einem der vorstehenden Ansprüche, **dadurch gekennzeichnet, daß** das Substrat (20) auf einer ersten Vakuumplatte (3) angesaugt wird, welche erhabene und vertiefte Bereiche (44, 46) aufweist.

16. Verfahren gemäß Anspruch 15, **dadurch gekennzeichnet, daß** das Substrat (20) auf einer ersten Vakuumplatte (3) angesaugt wird, welche erhabene und vertiefte Bereiche (44, 46) aufweist, wobei die erhabenen Bereiche (44) sich entlang der herauszuarbeitenden Teile (30) und die vertieften Bereiche (46) sich entlang des diese Teile (30) umgebenden Substratmaterials (29) erstrecken.

17. Verfahren gemäß Anspruch 16, **dadurch gekennzeichnet, daß** die herausgearbeiteten Teile (30) umgebende Substratteile (29) in die vertieften Bereiche (46) der ersten Vakuumplatte (3) eingesaugt werden.

18. Verfahren gemäß Anspruch 17, **dadurch gekennzeichnet, daß** das Substrat (20) auf einer ersten Vakuumplatte (3) befestigt wird, welche erhabene und vertiefte Bereiche aufweist, wobei die vertieften Bereiche sich entlang der herauszuarbeitenden Teile (30) und die erhabenen Bereiche sich entlang des diese Teile (30) umgebenden Substratmaterials (29) erstrecken.

19. Verfahren gemäß Anspruch 18, **dadurch gekennzeichnet, daß** die herausgearbeiteten Teile (30) nach dem lateralen Abtrennen in die vertieften Bereiche der ersten Vakuumplatte (3) eingesaugt werden.

20. Verfahren gemäß Anspruch 18 oder 19, **dadurch gekennzeichnet, daß** das plattenförmige Substrat (20) auf den erhabenen Bereichen adhäsiv fixiert wird.

21. Verfahren gemäß einem der vorstehenden Ansprüche, **dadurch gekennzeichnet, daß** mehrere Teile (30) gleichzeitig aus dem Substrat (20) herausgearbeitet werden.

22. Verfahren gemäß einem der vorstehenden Ansprüche, **dadurch gekennzeichnet, daß** erste, den herauszuarbeitenden Teilen (30) zugeordnete Bereiche und zweite, dem diese Teile (30) umgebende Bereiche des plattenförmigen Substrats (20) selektiv angesteuert angesaugt werden.

23. Verfahren gemäß einem der vorstehenden Ansprüche, **dadurch gekennzeichnet, daß** das plattenförmige Substrat (20) in einer Vertiefung der ersten Vakuumplatte (3) zentriert wird.

24. Verfahren gemäß einem der vorstehenden Ansprüche, **dadurch gekenzeichnet,** daß die Mehrzahl von Teilen aus einem Wafer herausgearbeitet wird.

25. Vorrichtung zur Herstellung einer Mehrzahl von Teilen (30) aus einem plattenförmigen Substrat (20) oder zur Herstellung eines gelochten plattenförmigen Substrats, insbesondere zur Durchführung eines Verfahrens gemäß einem der vorstehenden Ansprüche, umfassend
- eine erste Vakuumplatte (3) zur Befestigung des plattenförmigen Substrats (20),
- eine Einrichtung zum lateralen Abtrennen der Teile (30) aus dem Substrat (20), und
- eine Einrichtung zum Ablösen der abgetrennten Teile (30) von der ersten Vakuumplatte (3).

26. Vorrichtung gemäß Anspruch 25, **gekennzeichnet durch** eine zweite Vakuumplatte zum Abheben der Teile (30) von der ersten Vakuumplatte (3).

27. Vorrichtung gemäß Anspruch 26, **dadurch gekennzeichnet daß** die zweite Vakuumplatte komplementär zur ersten Vakuumplatte (3) aufgebaut ist.

28. Vorrichtung gemäß einem der vorstehenden Ansprüche, **gekennzeichnet durch** eine Einrichtung zum gleichzeitigen Ablegen mehrerer herausgearbeiteter Teile (30) in ein Magazin, insbesondere einem Waschmagazin (40).

29. Vorrichtung gemäß einem der vorstehenden Ansprüche, **gekennzeichnet durch** eine Kunststoffbeschichtung, vorzugsweise eine Teflonbeschichtung der ersten Vakuumplatte (3).

30. Vorrichtung gemäß einem der vorstehenden Ansprüche, **dadurch gekennzeichnet, daß** die Einrichtung zum lateralen Abtrennen der Teile (30) aus dem Substrat (20) eine Pulverstrahleinrichtung (14) umfaßt.

31. Vorrichtung gemäß einem der vorstehenden Ansprüche, **gekennzeichnet durch** eine Ultraschallschleifeinrichtung (14).

32. Vorrichtung gemäß einem der vorstehenden Ansprüche, **gekennzeichnet durch** eine erste Vakuumplatte (3) mit Kunststoffringen, insbesondere elastischen Ringen (9), welche entlang von vorgesehenen Trennlinien eines Substrats (20) verlaufen.

33. Vorrichtung gemäß einem der vorstehenden Ansprüche, **gekennzeichnet durch** eine erste Vakuumplatte (3) welche erhabene und vertiefte Bereiche (44, 46) aufweist.

34. Vorrichtung gemäß Anspruch 33, **dadurch gekennzeichnet, daß** die Form und Anordnung der Bereiche der Form der herauszuarbeitenden Teile (30) und der Form des diese Teile (30) umgebenden Substratmaterials (29) entspricht.

35. Vorrichtung gemäß Anspruch 33 oder 34, **dadurch gekennzeichnet, daß** erhabene Bereiche der ersten Vakuumplatte (3) zur Fixierung der herauszuarbeitenden Teile (30) und vertiefte Bereiche zur Aufnahme und Fixierung des oder der verbleibenden Substratreste (29) ausgebildet sind.

36. Vorrichtung gemäß Anspruch 33 oder 34, **dadurch gekennzeichnet, daß** vertiefte Bereiche der Vakuumplatte (3) zum Hineinsaugen der vom Substrat (20) abgetrennten Teile (30) ausgebildet sind.

37. Vorrichtung gemäß einem der vorstehenden Ansprüche, **dadurch gekennzeichnet, daß** die erste Vakuumplatte (3) erste Bereiche insbesondere zur Fixierung der abgetrennten Teile (30) und zumindest einen zweiten Bereich aufweist, wobei die ersten Bereiche und der zumindest eine zweite Bereich separat an eine Unterdruckerzeugungseinrichtung angeschlossen sind.

38. Vorrichtung gemäß einem der vorstehenden Ansprüche, **dadurch gekennzeichnet, daß** die erste Vakuumplatte (3) eine auswechselbare Auflage (12) für das Substrat (20) umfaßt.

39. Vorrichtung gemäß einem der vorstehenden Ansprüche, **dadurch gekennzeichnet, daß** die erste Vakuumplatte (3) eine Vertiefung zur Zentrierung des plattenförmigen Substrats (20) aufweist.

40. Verfahren zur Herstellung von Optokappen (72), bei welchem Fenster der Optokappen (72), insbesondere Glasfenster mit einem Verfahren oder einer Vorrichtung (1) gemäß einem der vorstehenden Ansprüche hergestellt werden.
